# FASCICULE DE BREVET EUROPEEN

(11) **EP 2 729 967 B1**
(45) Date de publication et mention de la délivrance du brevet: **22.07.2015**
(21) Numéro de dépôt: 12726464.6
(22) Date de dépôt: 30.04.2012
(51) Int. Cl.: H01L 31/048, H01L 31/05

(54) **Module photovoltaïque à conducteurs sous forme de rubans et son procédé de fabrication**
Fotovoltaikmodul mit Leitern in Form von Streifen und Verfahren zu seiner Herstellung
Photovoltaic module comprising conductors in the form of strips and its method of fabrication

(30) Priorité: 07.07.2011 FR 1156192
(43) Date de publication de la demande: 14.05.2014
(73) Titulaire: Commissariat à l'Énergie Atomique et aux Énergies Alternatives, 75015 Paris (FR)
(72) Inventeur: VOARINO, Philippe, F-06000 Nice (FR); LEFILLASTRE, Paul, F-75013 Paris (FR)
(74) Mandataire: Cabinet Laurent & Charras
(86) Numéro de dépôt international: PCT/FR2012/050958
(87) Numéro de publication internationale: WO 2013/004928

(56) Documents cités:
- EP-A2- 2 317 564
- WO-A1-2011/070240
- US-A1- 2009 218 651

## Description

### DOMAINE DE L'INVENTION

L'invention a trait au domaine des modules photovoltaïques, et plus particulièrement aux modules photovoltaïques dont les cellules photovoltaïques sont électriquement connectées par des rubans conducteurs, lesdites cellules étant encapsulées sous une pression réduite entre deux plaques.

### ETAT DE LA TECHNIQUE

Une cellule photovoltaïque est un dispositif semi-conducteur qui convertit un rayonnement incident, solaire en l'espèce, en courant électrique au moyen d'une jonction PN.

Plus particulièrement, les électrons produits sont collectés par un réseau d'électrodes métalliques étroites réalisées dans la masse de la cellule au contact de la ou des zones anodiques de celle-ci, et acheminés par ce réseau vers une ou plusieurs électrodes de plus grandes dimensions, usuellement désignées sous l'expression « *busbar* » ou *« barre omnibus* », et affleurant à la surface de la cellule.

Afin d'acheminer le courant électrique hors de la cellule, un connecteur électrique, désigné sous l'expression « pôle négatif », est alors placé au contact de chaque busbar. De même, un ou plusieurs connecteurs électriques sont également prévus au contact de la ou des zones cathodiques de la cellule, ces connecteurs électriques étant usuellement désignés sous l'expression de «pôles positifs ». La surface d'un busbar étant le plus souvent une bande rectiligne, un connecteur électrique prend ainsi la forme d'un ruban métallique. Dans certains types de cellules, un ou plusieurs pôles positifs par cellule prennent également la forme de ruban.

Par ailleurs, une cellule ne peut généralement pas, à elle toute seule, fournir un courant et une tension appropriée pour le fonctionnement des équipements électriques courants. Notamment, une cellule photovoltaïque fournit une tension inférieure au volt et un courant de l'ordre de la dizaine de milliampères par centimètre carré de cellule. Il convient donc de connecter en série et/ou en parallèle plusieurs cellules afin de fournir en sortie une tension et/ou un courant approprié. On parle alors de « module photovoltaïque ».

Ensuite, les cellules photovoltaïques sont des éléments fragiles, destinées le plus souvent à être utilisées dans des conditions environnementales difficiles (pluie, grêle, etc...). Aussi, les cellules photovoltaïques sont généralement pressées entre deux plaques de protection au moins une étant rigide et au moins une étant transparente en face avant de la cellule, par exemple des plaques en verre trempé, qui fournissent à la fois une protection contre les conditions environnementales difficiles et une rigidité suffisante pour la manipulation et le montage des modules photovoltaïques.

Enfin, toujours pour des questions de protection des cellules photovoltaïques contre les conditions environnementales, et notamment contre l'humidité et l'oxygène, qui provoquent une oxydation des cellules, celles-ci sont placées dans un environnement non oxydant et hermétique à l'air et à l'humidité.

Une première technique de fabrication d'un module photovoltaïque consiste ainsi à souder les connecteurs électriques sur les cellules, à connecter les cellules entre elles selon un schéma électrique souhaité, à noyer ensuite l'ensemble dans un matériau formant une capsule hermétique, par exemple dans de l'éthylène-acétate de vinyle, puis à presser les cellules ainsi noyées entre deux plaques rigides transparentes, par exemple en verre trempé.

Toutefois, le temps de fabrication d'un module photovoltaïque selon cette technique est très long, nécessite des phases de chauffage importantes pour faire fondre les matériaux de la capsule, de nombreux changements de matériels et de nombreuses opérations de nettoyage. Cette technique s'avère donc coûteuse. En outre, on observe une dégradation à long terme de la capsule qui ne joue plus son rôle protecteur contre l'air et l'humidité.

Une seconde technique « par pressage », décrite dans le document WO-A-2004/075304, a été développée pour répondre à ces inconvénients.

Cette technique par pressage consiste essentiellement à presser les cellules et leurs connecteurs entre deux plaques de protection transparentes, rigides et isolantes, en scellant les deux plaques entre elles au moyen d'un joint de scellement périphérique en matériau organique thermoplastique pour réaliser un boitier hermétique à l'air et à l'humidité. Parallèlement, lors de l'assemblage, il est créé dans le boitier une atmosphère de gaz neutre sous pression réduite. Les conducteurs électriques, qui sont pris en sandwich entre les cellules et les plaques de protection, sont maintenus en place lors de l'assemblage à l'aide d'une colle déposée sur les plaques, et de la pression exercée par les plaques de protection sur les connecteurs. Cette technique a ainsi permis une réduction très sensible des coûts de fabrication des modules photovoltaïques.

Toutefois, cette technique présente encore un certain nombre d'inconvénients concernant les connecteurs électriques sous forme de ruban.

Tout d'abord, les rubans ne sont pas directement solidarisés aux busbars mais reportés sur celles-ci lors de l'assemblage. Il convient donc de procéder à un alignement précis d'un ruban avec son busbar, ce qui nécessite donc d'utiliser un équipement couteux. En effet, toute erreur d'alignement a pour conséquence de placer une partie du ruban au dessus d'une surface de la cellule dédiée à la captation du flux de lumière incident, ou surface « utile ». On notera que la surface utile d'une cellule photovoltaïque est très loin de représenter la surface totale d'une cellule, notamment en raison de la présence du réseau d'électrodes de collecte. Ainsi donc, même un ombrage, que l'on pourrait juger a priori minime, a un impact important sur la quantité de courant pouvant être produite par une cellule. A titre d'exemple, pour une cellule photovoltaïque carrée de 125 millimètres de côté, capable de produire une densité maximale de courant de 33 mA/cm², et comprenant deux busbars de 2 millimètres de largeur, une erreur d'alignement d'un millimètre des rubans connecteurs sur les busbars entraine une chute de 0,2 ampère du courant pouvant être produit par la cellule.

Ensuite, lors de l'utilisation du module photovoltaïque, on observe que les moyens mis en oeuvre pour maintenir les rubans connecteurs en place ne sont pas suffisants. En effet, le module photovoltaïque peut subir des cycles thermiques d'une très grande ampleur. D'ailleurs, des normes ont été mises au point sur ce sujet et préconisent que les modules photovoltaïques, les cellules photovoltaïques et leurs connecteurs associés doivent être conçus pour résister à des cycles thermiques allant de -40°C à +85°C (par exemple norme NF EN 61215 et norme NF EN 61640). Cependant, les coefficients de dilation thermiques d'une cellule, des rubans connecteurs et des plaques rigides sont différents, de sorte que ces éléments se dilatent et se contractent différemment. Les rubans pressés entre les cellules et les plaques de protection subissent ainsi de très fortes contraintes mécaniques qui les amènent à se déformer et quitter leur forme initiale rectiligne.

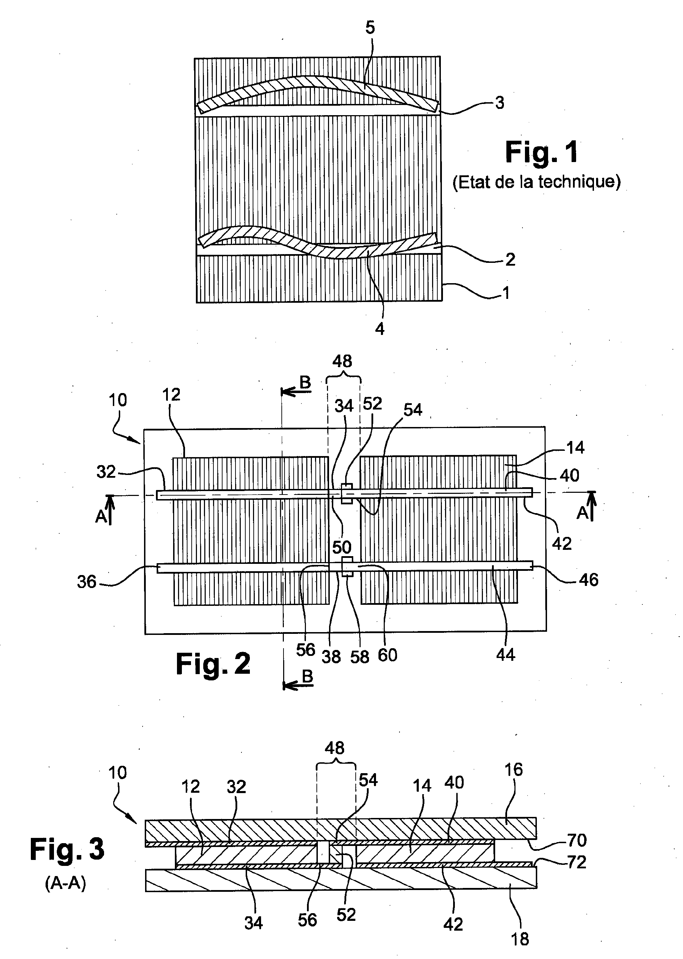

La figure 1 est une vue de dessus d'une cellule photovoltaïque **1** d'un module photovoltaïque du commerce fabriqué selon la technique par pressage. La cellule **1** comprend deux busbars **2, 3** sur, lesquelles sont initialement pressés deux rubans en cuivre **4, 5** rectilignes. Après avoir subi des cycles thermiques importants, on observe que les rubans **4, 5** se sont déformés comme illustré. Non seulement, les rubans **4, 5** font un ombrage important de la cellule **1**, mais en outre ils n'assurent qu'un contact électrique très partiel avec les barres omnibus **2, 3**.

Ensuite, les rubans connecteurs subissent une contrainte mécanique non homogène en raison des irrégularités de surface des plaques de protection, des épaisseurs différentes de cellules du fait des tolérances de fabrication, etc... Comme les rubans ne sont pas soudés aux cellules, et sont maintenus en place sur les busbars essentiellement par la pression exercée par les plaques de protection, cette contrainte mécanique peut devenir critique. Or, les déformations dites de « basse fréquence » des plaques de verre réalisées par des techniques classiques ont une amplitude de l'ordre de 0,5 millimètre pour une longueur de 300 millimètres. Dans un tel cas, la qualité d'un module photovoltaïque est donc en partie aléatoire.

Les inconvénients décrits ci-dessus sont fortement interdépendants, le ruban subissant des contraintes mécaniques non homogènes, phénomène qui est amplifié par des cycles thermiques importants, menant ainsi les rubans à se déformer et/ou à se désaligner des busbars, générant donc une perte de contact électrique résultant de l'ombrage, ce qui peut conduire au non fonctionnement ou au dysfonctionnement d'un module photovoltaïque.

### EXPOSE DE L'INVENTION

Le but de la présente invention est de proposer un module photovoltaïque réalisé selon la technologie par pressage permettant d'aligner, et de maintenir alignés des rubans connecteurs avec précision, et permettant à ces rubans de demeurer au contact des cellules photovoltaïques en cas de fortes irrégularités des surfaces contre lesquelles ils sont pressés et en cas de cycles thermiques de forte amplitude.

A cet effet, l'invention a pour objet un module photovoltaïque comprenant :
▪ une plaque supérieure transparente à un rayonnement incident et une plaque inférieure, électriquement isolantes, et scellées l'une sur l'autre de manière à définir un boitier hermétique ;
▪ des cellules photovoltaïques pressées entre les plaques supérieure et inférieure ;
▪ au moins deux contacts électriquement conducteurs disposés sur au moins une face de chaque cellule photovoltaïque, au moins un contact électrique se présentant sous la forme d'un ruban ; et
▪ des éléments connectant électriquement les contacts de chaque cellule avec les contacts d'au moins une cellule adjacente.

Selon l'invention, au moins un ruban de chaque cellule est logé dans un sillon ménagé dans la plaque au regard de celui-ci, le sillon étant défini par :
▪ une profondeur comprise entre un quart et trois quart de l'épaisseur du ruban dans un état non compressé ;
▪ une largeur supérieure ou égale à la largeur que le ruban présente à 85°C ; et
▪ une longueur supérieure ou égale à la longueur que le ruban présente à 85°C.

En d'autres termes :
▪ en logeant un ruban dans un sillon, un alignement précis du ruban avec un busbar peut être réalisé simplement puisque le ruban est guidé et ne glisse pas ;
▪ le sillon a une profondeur inférieure à l'épaisseur du ruban et supérieure à la somme de la tolérance de fabrication concernant l'épaisseur du ruban, de la tolérance de fabrication concernant la profondeur du sillon et des amplitudes maximales des irrégularités de surfaces de la plaque protectrice. De cette manière, on garantit l'absence de jeu lorsque la plaque comportant le sillon est pressée contre une cellule, et une profondeur suffisante pour assurer le maintien en place du ruban et un guidage de celui-ci lors de ses dilatations et contractions. En outre, puisque la profondeur du sillon est inférieure à l'épaisseur du ruban, ce dernier peut être compressé fortement contre la cellule avec une diminution de son épaisseur du fait de l'écrasement qu'il subit, ce qui assure le maintien en place du ruban et son contact avec la cellule. On notera d'ailleurs que la pression exercée sur le ruban est plus uniforme que celle exercée par une plaque non pourvue de sillon. Ceci permet d'atténuer, voire d'éliminer, l'impact des irrégularités de surface de la plaque protectrice ;
▪ le sillon a une largeur qui lui permet de ne jamais comprimer latéralement le ruban lorsque la largeur de celui-ci augmente par dilatation et donc évite que le ruban ne se plie et perde le contact avec la cellule ; et
▪ le sillon a une longueur supérieure à la longueur que peut présenter le ruban suite à une dilatation à une température d'au moins 85°C, température maximale des normes NF EN 61215 et NF EN 61640. Ainsi, le ruban est guidé dans sa dilatation par le sillon et ne sort pas de celui-ci. Avec un sillon plus court, l'extrémité du ruban qui sortirait du sillon sous l'effet de la dilatation serait susceptible de se vriller, ce qui provoquerait une sortie du ruban hors du sillon.

Selon un mode de réalisation, la profondeur du sillon est sensiblement égale à la moitié de l'épaisseur du ruban dans l'état non compressé. Il a ainsi été observé que cette profondeur permet d'obtenir les effets décrits ci-dessus quel que soit le matériau constitutif des rubans, ce qui simplifie la conception et la fabrication des modules photovoltaïques.

Selon un mode de réalisation, le module photovoltaïque comprend des cellules alignées en enfilade, des rubans disposés sur les faces desdites cellules étant alignés et logés dans un unique sillon s'étendant sur au moins la longueur totale des cellules alignées, ce qui simplifie la fabrication de la plaque de protection.

En variante, avec un module photovoltaïque comprenant des cellules alignées en enfilade, ledit module comprend des rubans desdites cellules, lesdits rubans étant alignés et logés dans une pluralité de sillons disjoints s'étendant sur tout ou partie de la longueur de chaque cellule. Notamment, les sillons adjacents sont espacés d'une distance inférieure à la longueur d'un espace séparant des cellules adjacentes d'au moins une valeur égale à une dilatation linéaire du matériau constitutif des rubans, induite par une variation de température de 25 °C à 85 °C.

Selon un mode de réalisation de l'invention, une surface de la plaque au fond du sillon comporte une texturation micrométrique, notamment un réseau de prismes micrométriques arrondis. Ceci permet par exemple d'emprisonner de l'air ou un gaz entre le ruban et la plaque de protection, et donc de créer une différence d'indices de réfraction entre ces deux éléments, et corolairement de rediriger la lumière incidente sur les cellules par réfraction et réflexion. Les espaces de la texturation en regard du ruban peuvent également être remplis d'un autre matériau, ce qui permet une adaptation optimale des indices.

De façon plus générale, la texturation met en oeuvre une fonction optique pour le rayonnement incident choisie parmi la réfraction, la réflexion, la diffusion, la diffraction et le guidage d'onde.

Plus particulièrement, la texturation est un réseau de prismes qui permet de dévier une partie de la lumière incidente sur le sillon vers la surface utile de la cellule photovoltaïque. Un réseau de diffraction nanométrique peut également être utilisé dans ce but.

Selon un mode de réalisation, qu'au moins deux rubans sont disposés sur chaque face de chaque cellule, les rubans de la première face étant disposés sur un pôle positif de la cellule, et les rubans de la seconde face étant disposés sur un pôle négatif de la cellule, et en ce que les éléments de connexion connectent les rubans de la première face d'une cellule respectivement aux rubans de la seconde face d'une cellule adjacente.

L'invention a également pour objet un procédé de fabrication d'un module photovoltaïque du type précité, qui consiste :
▪ à former des sillons dans l'une et/ou l'autre de la plaque supérieure et de la plaque inférieure, les sillons présentant :
   ∘ une profondeur comprise entre un quart et trois quart de l'épaisseur du ruban dans un état non compressé ;
   ∘ une largeur supérieure ou égale à la largeur que le ruban présente à 85°C ; et
   ∘ une longueur supérieure ou égale à la longueur que le ruban présente à 85 °C,
▪ à empiler la première plaque, les cellules et les contacts électriques, et la seconde plaque, chaque sillon logeant un ruban ; et
▪ à sceller l'empilement ainsi réalisé, par collage ou par pressage ou par soudure.

Notamment, les sillons sont formés par gravure laser.

### BREVE DESCRIPTION DES FIGURES

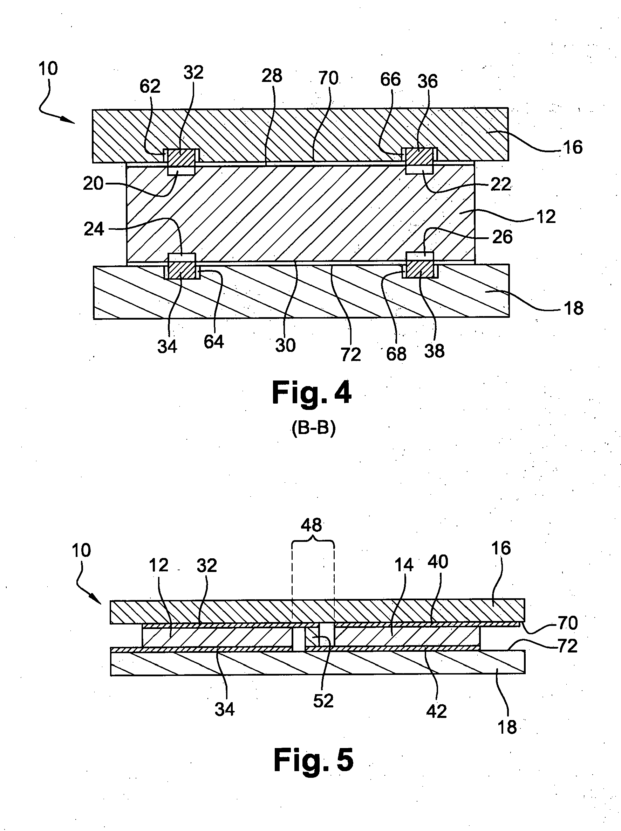

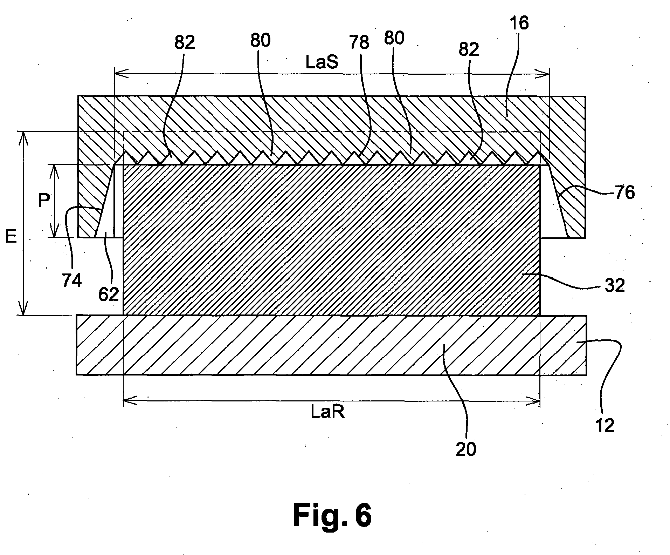

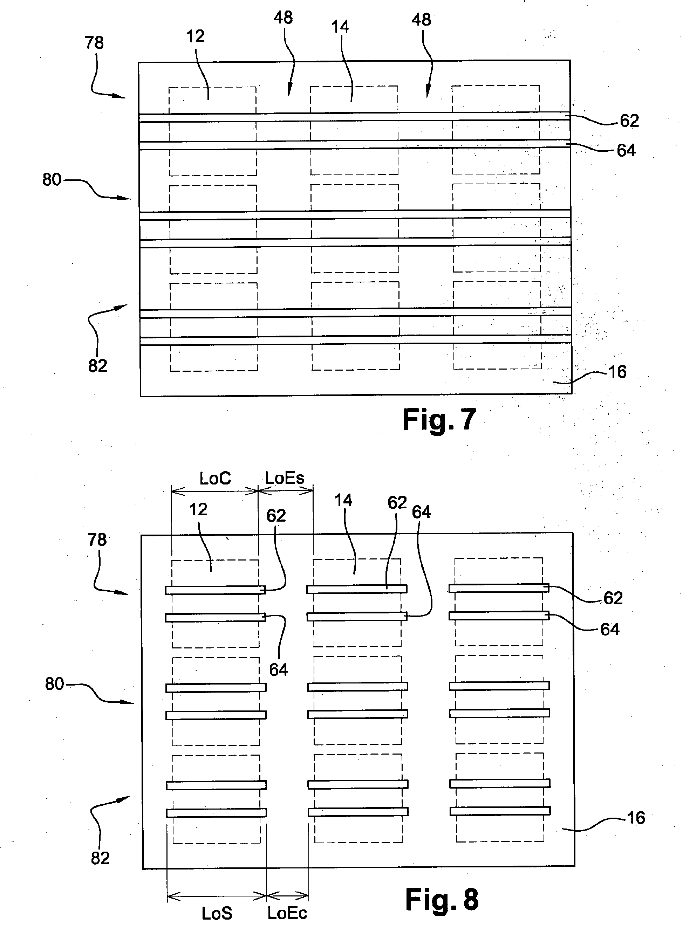

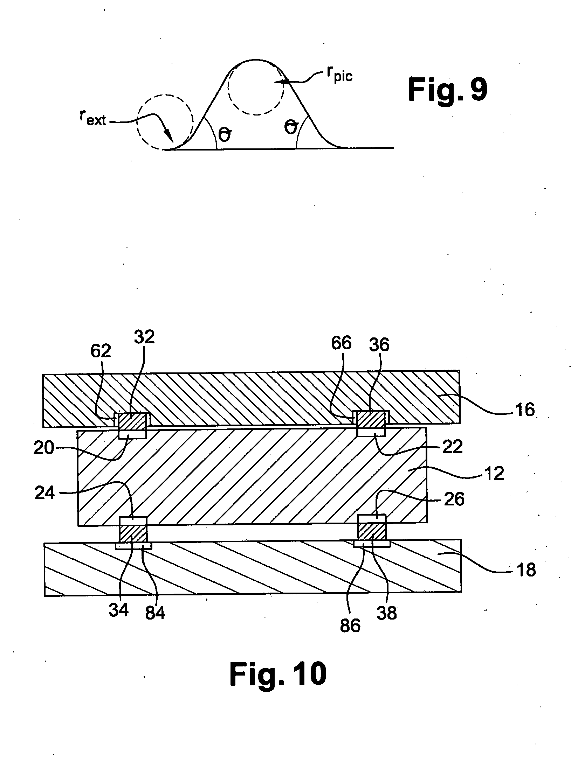

L'invention sera mieux comprise à la lecture de la description qui va suivre, donnée à titre d'exemple, et réalisée en relation avec les dessins annexés, dans lesquels des références identiques désignent des éléments identiques ou analogues fonctionnellement, et dans lesquels :
▪ la figure 1 est une vue schématique de dessus d'une cellule photovoltaïque d'un module photovoltaïque de l'état de la technique, dont les rubans connecteurs se sont déformés suite à grand nombre de cycles thermiques ;
▪ la figure 2 est une vue schématique de dessus de deux cellules adjacentes connectées en série d'un module photovoltaïque selon l'invention ;
▪ la figure 3 est une vue schématique en coupe du module de la figure 2 selon le plan A-A ;
▪ la figure 4 est une vue schématique en coupe du module de la figure 2 selon le plan B-B ;
▪ la figure 5 est une vue schématique en coupe d'un module selon une autre variante de l'invention dans lequel les rubans en face d'une cellule sont connectés avec les rubans en face arrière d'une autre cellule adjacente ;
▪ la figure 6 est une vue de détail de la figure 4 correspondant à la zone en pointillés ;
▪ la figure 7 est une vue schématique de dessus illustrant des sillons continus d'une plaque de protection ;
▪ la figure 8 est une vue schématique de dessus illustrant des sillons discontinus d'une plaque de protection ;
▪ la figure 9 est une vue en coupe d'une autre variante de prismes micrométriques disposés au fond des sillons d'un module photovoltaïque selon l'invention ; et
▪ la figure 10 est une vue schématique en coupe d'un module photovoltaïque selon l'invention dans lequel une partie seulement des rubans connecteurs est logée dans des sillons des plaques protectrices, par exemple les rubans supérieurs.

### DESCRIPTION DETAILLEE DE L'INVENTION

Un module photovoltaïque **10** selon l'invention est illustré aux figures 2 à 4. Le module **10** comprend des cellules photovoltaïques identiques à homo-jonction **12, 14**, au nombre de deux dans l'exemple illustré dans les figures 2 à 4. Les cellules photovoltaïques **12, 14** sont pressées entre une plaque de protection supérieure transparente **16**, ou plaque « avant », et une plaque de protection inférieure **18**, ou plaque « arrière ». Les plaques de protection **16, 18** sont rigides et électriquement isolantes, et sont par exemple réalisées en verre trempé. Les plaques **16, 18** sont scellées l'une sur l'autre au moyen d'un joint de scellement (non représenté) de manière à définir un espace intérieur hermétique à l'air et à l'humidité, ledit espace étant rempli d'un gaz neutre, par exemple de l'argon, et sous une pression réduite inférieure à 500 millibars, et préférentiellement une pression inférieure à 300 millibars.

Chaque cellule photovoltaïque **12, 14** comporte par ailleurs deux busbars **20,, 22, 24, 26** sur chacune de ses faces, les deux busbars **20, 22** de la face supérieure **28** de la cellule correspondant par exemple à des barres anodiques de la cellule, et les deux busbars **24, 26** de la face inférieure **30** de la cellule étant des barres cathodiques de la cellule.

Un ruban conducteur **32-44** de section rectangulaire, par exemple en cuivre, ou en un matériau de soudure étamé par du cuivre, est en outre compressé sur chaque busbar **20-22** par les plaques de protection **16, 18**. Les rubans **32-44** sont par exemple identiques et forment les connecteurs de la cellule pour la collecte du courant généré par celle-ci.

Les cellules **12, 14** sont espacées les unes des autres par des zones de connexion **48** dans lesquelles sont disposés des éléments de connexion **50-60** connectant électriquement en série les cellules. Par exemple, les éléments de connexion en série de deux cellules **12, 14** adjacentes comprennent des extrémités **50, 56** des rubans inférieurs **34, 38** de la cellule **12** qui se prolongent dans la zone de connexion **48** séparant les deux cellules **12, 14**, deux pièces conductrices **52**, **58** pressées respectivement sur les extrémités **50, 56** des rubans inférieurs, et des extrémités **54**, **60** des rubans supérieurs **40**, **44** de la cellule **14** qui se prolongent dans la zone de connexion **48** et qui sont pressées sur les pièces conductrices **52,58**.

On se reportera avantageusement à la demande WO 2004/0753304 pour des exemples d'éléments de connexion, de joints de scellement, d'agencements de busbars et de rubans connecteurs, l'invention pouvant s'appliquer à n'importe lequel des modes de réalisation décrits dans ce document, étant entendu qu'à la différence de ce dernier, l'invention considère une autre manière de maintenir les rubans connecteurs sur les busbars.

Selon l'invention, chaque ruban **32-44** est logé dans un sillon **62-68** ménagé, par exemple par gravure laser, au sein des faces internes **70, 72** des plaques de protection **16, 18**.

Le sillon peut également être formé par moulage, par gravure chimique, ou par sciage.

La figure 5 est une vue schématique en coupe d'une variante qui diffère de ce qui précède en ce que les rubans supérieurs **32, 36** de la cellule **12** sont respectivement connectés aux rubans inférieurs **42,46** de la cellule **14**.

En se référant à la figure **6**, qui est une vue élargie d'un sillon **62** et d'un ruban **32**, la profondeur *P* d'un sillon est définie en fonction notamment de l'épaisseur *E* du ruban que le sillon loge, l'épaisseur *E* étant l'épaisseur du ruban non compressé, illustré sous forme de pointillés à la figure 5. Lors de l'assemblage du module **10**, les plaques protectrices **16, 18** sont pressées sur les cellules photovoltaïques de manière à former un ensemble mécaniquement solidaire, l'empilement ainsi réalisé étant maintenu dans cet état pressé par un joint de scellement durci et/ou par des systèmes de fixation mécanique. La pression exercée par les plaques protectrices **16, 18** a donc également pour effet de presser les rubans **32-34** contre les cellules **12, 14**, ce qui maintient les rubans en place et les compriment.

La profondeur *P* est suffisante pour que le ruban reste logé dans le sillon, par exemple en cas de choc, et pour guider le ruban lors de sa dilatation/contraction suite à des variations de température. Par ailleurs, la profondeur *P* est inférieure à l'épaisseur *E* du ruban non compressé pour garantir que le fond du sillon appuie sur le ruban, et presse ce dernier contre une cellule. Pour une même géométrie de sillon et une même géométrie de ruban, la pression diffère cependant en fonction des propriétés thermomécaniques du matériau constitutif du ruban, et notamment son module d'Young et de sa capacité calorifique, etc...Le cas échéant, la profondeur du sillon est donc avantageusement optimisée également en fonction des propriétés thermomécaniques du ruban.

En outre, la pression exercée sur le ruban est également choisie pour que le ruban se conforme aux irrégularités de planéité de la plaque de protection et de la cellule entre lesquels le ruban est intercalé.

Il a ainsi été observé qu'une profondeur *P* du sillon comprise entre un quart et trois quart de l'épaisseur *E* du ruban dans un état non compressé, et avantageusement sensiblement égale à la moitié de l'épaisseur *E* non compressée, permet un maintien en place et un guidage de qualité pour une grande variété de matériaux constitutifs des rubans.

Le sillon peut cependant être plus profond. Il est alors avantageusement tenu compte des tolérances de fabrication sur l'épaisseur *E* du ruban, de la tolérance de fabrication sur la profondeur du sillon, des propriétés thermomécaniques du ruban et de la planéité locale de la plaque, afin de garantir que le ruban reste toujours pressé contre la cellule quelque soit la température.

Préférentiellement, le sillon est gravé en utilisant une technique qui contrôle en temps réel, au moyen d'un système optique par exemple, la planéité locale de la gravure de la plaque de protection, ce qui permet d'asservir en profondeur la gravure du sillon, et donc d'obtenir une profondeur contrôlée du sillon. Ceci a pour effet de diminuer, voire d'éliminer les irrégularités surfaciques des plaques.

La largeur *LaS* du sillon est quant à elle choisie supérieure, et de préférence légèrement supérieure à la largeur *LaR* maximale que peut prendre le ruban lors d'un cycle thermique, de sorte qu'il n'y a jamais de compression exercée sur le ruban par les parois latérales **74, 76** du sillon. On notera que la largeur *LaS* du sillon dépend donc de la température maximale que le ruban est supposé rencontrer en fonctionnement. La température de 85 °C représentant une température maximale généralement observée, la largeur maximale du ruban est donc définie pour cette température, bien qu'une autre température puisse servir de base à la détermination de la géométrie, longueur, largeur et profondeur, du sillon. La largueur *LS* du sillon peut également tenir compte de la tolérance de fabrication sur la largeur *LaR* du ruban afin de garantir pour n'importe quel ruban, qu'il n'y ait jamais de compression de celui-ci.

Selon une première variante de l'invention illustrée à la figure 7, des sillons continus **62**, **64** sont réalisés sur la longueur des plaques de protection, chaque sillon logeant donc les rubans alignés d'une rangée **78, 80, 82** de cellules photovoltaïques. Les sillons sont notamment présents sur toute la longueur des cellules ainsi qu'entre les zones **48** espaçant celles-ci. Ceci offre une longueur suffisante pour guider et loger les rubans lors de leur dilatation sous l'effet de températures importantes, et notamment une longueur suffisante pour guider et loger les rubans à la température maximale rencontrée en utilisation, avantageusement une longueur suffisante pour guider et loger les rubans à la température de 85°C.

Selon une seconde variante de l'invention illustrée à la figure 8, pour chaque alignement de rubans d'une rangée **78, 80, 82**, des sillons discontinus sont réalisés sur la longueur des plaques de protection afin notamment d'éviter des zones de rupture importantes. Chaque sillon est ainsi formé de segments de sillons alignés **62, 64** destinés à loger les rubans des cellules.

Chaque segment de sillon a une longueur *LoS* suffisante pour guider et loger les rubans suite de leur dilatation sous l'effet de températures importantes, et notamment une longueur suffisante pour guider et loger les rubans à la température maximale rencontrée en utilisation, avantageusement une longueur suffisante pour guider et loger les rubans à la température de 85°C. Par exemple, un ruban de cuivre, qui a une longueur à vide *L₀*, définie à la température 25°C égale à 320 millimètres, subit une dilatation *ΔL* de sa longueur de 160 micromètres à 85 °C. La longueur *LoS* d'un segment de sillon est donc dans ce cas supérieure à la somme de la longueur *LoC* d'une cellule et de sa dilatation *ΔL.*

De manière avantageuse, une marge *M* supplémentaire est prévue pour faciliter le positionnement d'un ruban dans le segment de sillon lors de l'assemblage du module photovoltaïque, par exemple une marge de 500 micromètres. La longueur *LoS* du sillon est alors supérieure ou égale à la somme de la longueur *LoC*, de la dilation *ΔL* et de la marge *M*. La longueur de l'écartement *LoEc* entre deux segments de sillons alignés consécutifs est alors égale à la différence entre la longueur *LoEs* de l'espacement de deux cellules consécutives dans une rangée et de la longueur *LoS* des segments de sillon.

Bien entendu, il est possible de combiner des sillons continus et des segments discontinus dans un même module photovoltaïque.

En se référant de nouveau à la figure 6, les parois latérales **74, 76** des sillons ont optionnellement un profil évasé permettant une insertion aisée des rubans dans les sillons. Optionnellement, le fond des sillons met en oeuvre une fonction optique qui permet de rediriger la lumière en obtenant une variation importante d'indices de réfraction vers la surface utile des cellules, et notamment hors des busbars. Ceci permet de minimiser les pertes par réflexion qui peuvent représenter jusqu'à 4% du flux incident sur une cellule de 125*125 millimètres carrés munie de deux rubans de 2 millimètres de largeur.

A cette fin, une texturation micrométrique est réalisée sur la surface **78** de la plaque au fond du sillon **62**, et plus particulièrement un réseau régulier de motifs micrométriques **80**. De cette manière, de l'air ou un gaz est emprisonné dans les espaces **82** définis par la texturation. En variante, ces espaces **82** sont remplis avantageusement du matériau du ruban, ce qui permet une adaptation optimale des indices de réfraction. La taille des motifs de la texturation est inférieure à 200 micromètres, de préférence inférieure ou égale à 50 micromètres, afin de ne pas risquer une non planéité basse fréquence et donc une courbure locale du ruban.

Sur la figure 6, le réseau de motifs micrométriques **80** est un réseau de prismes micrométriques. De manière avantageuse, le réseau de motifs micrométriques **80** est un réseau de prismes micrométriques arrondis, tel qu'illustré à la figure 9. Par exemple, des prismes arrondis ayant un rayon de pic *r_{pic}* de 2,5 micromètres, un rayon extérieur *rₑₓₜ* de 5 micromètres et un angle de prisme **θ** de 43°C, permettent de récupérer au minimum 0,2% du flux incident total sur la cellule, ce qui correspond à une densité de courant de 0,07 mA/cm² pour une cellule produisant une densité de courant maximale de 33 mA/cm².

De manière avantageuse, le réseau de motifs micrométriques **80** en fond de sillon peut également être conçu pour mettre en oeuvre une fonction de diffusion optique ou une fonction de diffraction optique. Dans ce cas, une partie du flux incident sur le fond du sillon est déviée vers la surface utile d'une cellule pour son absorption, et ce sans aucune structure additionnelle, par exemple montée au dessus de la plaque et faisant ombrage à la cellule.

Enfin, le réseau peut être recouvert d'une couche réfléchissante pour rediriger la lumière vers la plage supérieure afin d'être réfléchie à nouveau vers la surface utile de la cellule.

Les sillons peuvent être réalisés selon différentes techniques en fonction des matériaux constitutifs des plaques de protection, et par exemple par :
▪ une gravure par évaporation au moyen d'un laser CO₂, ce qui permet d'avoir un état de surface rugueux des sillons ;
▪ une gravure par ablation au moyen d'un laser femto-seconde, ce qui permet d'avoir un état de surface lisse des sillons;
▪ une gravure par rupture de liaison moléculaire au moyen d'un laser Excimer ;
▪ un emboutissage ou une abrasion mécanique ;
▪ un thermoformage ou un moulage lors de la fabrication des plaques de protection.

On comprendra que dans les figures, les dimensions des rubans, des sillons et des busbars ont été exagérément agrandies pour des raisons de compréhension.

Dans les modes de réalisations décrits, tous les rubans connecteurs sont logés dans des sillons. En variante, comme illustré à la figure 10, seulement une partie des rubans, par exemple les rubans sur la face supérieure de cellule, sont logés dans des sillons. Les autres rubans sont montés de manière classique, par exemple sur des bandes adhésives **84, 86** réalisées sur la plaque de protection correspondante.

De même, il a été décrit des cellules photovoltaïques à homo-jonction. L'invention s'applique à tout type de cellule photovoltaïque, par exemple des cellules mono-faciales, des cellules bifaciales, des cellules à homo-jonction, des cellules à hétérojonction, des cellules de type P, des cellules de type N, ...

## Revendications

1. Module photovoltaïque (10) comprenant :
▪ une plaque supérieure (16) transparente à un rayonnement incident et une plaque inférieure (18), électriquement isolantes, et scellées l'une sur l'autre de manière à définir un boitier hermétique ;
▪ des cellules photovoltaïques (12, 14) pressées entre les plaques supérieure et inférieure (16, 18) ;
▪ au moins deux contacts électriquement conducteurs (32-44) disposés sur au moins une face de chaque cellule photovoltaïque (12, 14), au moins un contact électrique (32-44) se présentant sous la forme d'un ruban ; et
▪ des éléments (52-56) connectant électriquement les contacts de chaque cellule avec les contacts d'au moins une cellule adjacente ;
***caractérisé* en ce qu'**au moins un ruban (32-44) de chaque cellule (12, 14) est logé dans un sillon (62-68) ménagé dans la plaque (16, 18) au regard de celui-ci, le sillon (62-68) étant défini par :
▪ une profondeur comprise entre un quart et trois quarts de l'épaisseur du ruban (32-44) dans un état non compressé ;
▪ une largeur supérieure ou égale à la largeur que le ruban (32-44) présente à 85°C ; et
▪ une longueur supérieure ou égale à la longueur que le ruban (32-44) présente à 85°C.

2. Module photovoltaïque selon la revendication 1, ***caractérisé* en ce que** la profondeur du sillon (62-68) est sensiblement égale à la moitié de l'épaisseur du ruban (32-44) dans l'état non compressé.

3. Module photovoltaïque selon la revendication 1 ou 2, ***caractérisé* en ce qu'**il comprend des cellules alignées en enfilade (78, 80, 82), des rubans disposés sur les faces desdites cellules étant alignés et logés dans un unique sillon (62, 64) s'étendant sur au moins la longueur totale de cellules alignées.

4. Module photovoltaïque selon la revendication 1 ou 2, ***caractérisé* en ce qu'**il comprend des cellules alignées en enfilade (78, 80, 82), des rubans desdites cellules étant alignés et logés dans une pluralité de sillons disjoints (62, 64) s'étendant sur tout ou partie de la longueur de chaque cellule.

5. Module photovoltaïque selon la revendication 4, ***caractérisé* en ce que** des sillons adjacents sont espacés d'une distance inférieure à la longueur d'un espace séparant des cellules adjacentes d'au moins une valeur égale à la dilatation linéaire du matériau des rubans induite par une variation de température de 25 °C à 85 °C.

6. Module photovoltaïque selon l'une quelconque des revendications précédentes, ***caractérisé* en ce qu'**une surface de la plaque au fond du sillon comporte une texturation micrométrique (80).

7. Module photovoltaïque selon la revendication 6, *caractérisé* en ce la texturation (80) met en oeuvre une fonction optique pour le rayonnement incident choisie parmi la réfraction, la réflexion, la diffusion, la diffraction et le guidage d'onde.

8. Module photovoltaïque selon la revendication 6 ou 7, ***caractérisé* en ce que** la texturation (80) est un réseau de prismes.

9. Module photovoltaïque selon l'une quelconque des revendications précédentes, ***caractérisé* en ce qu'**au moins deux rubans sont disposés sur chaque face de chaque cellule, les rubans de la première face étant disposés sur un pôle positif de la cellule, et les rubans de la seconde face étant disposés sur un pôle négatif de la cellule, et **en ce que** les éléments de connexion connectent les rubans de la première face d'une cellule respectivement aux rubans de la seconde face d'une cellule adjacente.

10. Procédé de fabrication d'un module photovoltaïque comprenant :
▪ une plaque supérieure (16) transparente à un rayonnement incident et une plaque inférieure (18), électriquement isolantes, et scellées l'une sur l'autre de manière à définir un boitier hermétique ;
▪ des cellules photovoltaïques (12, 14) pressées entre les plaques supérieure et inférieure (16, 18) ;
▪ au moins deux contacts électriquement conducteurs (32-44) disposés sur au moins une face de chaque cellule photovoltaïque (12, 14), au moins un contact électrique (32-44) se présentant sous la forme d'un ruban ; et
▪ des éléments (52-56) connectant électriquement les contacts de chaque cellule avec les contacts d'au moins une cellule adjacente ;
***caractérisé* en ce qu'**il consiste :
▪ à former des sillons dans l'une et/ou l'autre de la plaque supérieure et de la plaque inférieure, les sillons présentant :
∘ une profondeur comprise entre un quart et trois quart de l'épaisseur du ruban dans un état non compressé ;
∘ une largeur supérieure ou égale à la largeur que le ruban présente à 85°C ; et
∘ une longueur supérieure ou égale à la longueur que le ruban présente à 85°C,
▪ à empiler la première plaque, les cellules et les contacts électriques, et la seconde plaque, chaque sillon logeant un ruban ;
▪ à sceller l'empilement ainsi réalisé, par collage ou par pressage ou par soudure.

11. Procédé de fabrication d'un module photovoltaïque selon la revendication 10, ***caractérisé* en ce que** les sillons sont formés par gravure laser.

## Patentansprüche

1. Fotovoltaikmodul (10), Folgendes aufweisend:
▪ eine für einfallende Strahlung durchlässige obere Platte (16) und eine untere Platte (18), die elektrisch isolierend und miteinander verkapselt sind, um ein hermetisches Gehäuse zu bilden;
▪ Fotovoltaikzellen (12, 14), die zwischen der oberen und unteren Platte (16, 18) eingepresst sind;
▪ mindestens zwei elektrisch leitende Kontakte (32 - 44), die auf mindestens einer Seite jeder Fotovoltaikzelle (12, 14) angeordnet sind, wobei sich mindestens ein elektrischer Kontakt (32 - 44) in Form eines Bands darstellt; und
▪ Elemente (52 - 56), welche die Kontakte jeder Zelle elektrisch mit den Kontakten mindestens einer Nachbarzelle verbinden;
**dadurch gekennzeichnet, dass** mindestens ein Band (32 - 44) jeder Zelle (12, 14) in einer Furche (62 - 68) in der Platte (16, 18) dieser zugewandt ausgebildet ist, wobei die Furche (62 - 68) definiert ist durch:
▪ eine Tiefe, die zwischen einem Viertel und Dreiviertel der Dicke des Bands (32 - 44) in einem nicht komprimierten Zustand beträgt;
▪ eine Breite, die größer oder gleich der Breite ist, die das Band (32 - 44) bei 85°C aufweist; und
▪ eine Länge, die größer oder gleich der Länge ist, die das Band (32 - 44) bei 85°C aufweist.

2. Fotovoltaikmodul nach Anspruch 1, **dadurch gekennzeichnet, dass** die Tiefe der Furche (62 - 68) im Wesentlichen gleich der Hälfte der Dicke des Bands (32 - 44) im nicht komprimierten Zustand ist.

3. Fotovoltaikmodul nach Anspruch 1 oder 2, **dadurch gekennzeichnet, dass** es aufgereiht ausgerichtete Zellen (78, 80, 82) umfasst, wobei auf den Seiten der Zellen angeordnete Bänder in einer einzigen Furche (62, 64) ausgerichtet und untergebracht sind, die sich über mindestens die gesamte Länge der ausgerichteten Zellen erstreckt.

4. Fotovoltaikmodul nach Anspruch 1 oder 2, **dadurch gekennzeichnet, dass** es aufgereiht ausgerichtete Zellen (78, 80, 82) umfasst, wobei Bänder dieser Zellen in mehreren eigenständigen Furchen (62, 64) ausgerichtet und untergebracht sind, die sich über die gesamte oder einen Teil der Länge jeder Zelle erstrecken.

5. Fotovoltaikmodul nach Anspruch 4, **dadurch gekennzeichnet, dass** benachbarte Furchen um eine Distanz beanstandet sind, die kleiner als die Länge eines benachbarte Zellen trennenden Raums ist, und zwar um einen Wert, der gleich der linearen Ausdehnung des Materials der Bänder ist, die durch eine Temperaturveränderung von 25°C auf 85°C induziert wird.

6. Fotovoltaikmodul nach einem der vorhergehenden Ansprüche, **dadurch gekennzeichnet, dass** eine Oberfläche der Platte am Grund der Furche eine mikrometrische Texturierung (80) hat.

7. Fotovoltaikmodul nach Anspruch 6, **dadurch gekennzeichnet, dass** die Texturierung (80) eine optische Funktion für die einfallende Strahlung bewirkt, die aus Refraktion, Reflexion, Diffusion, Diffraktion und Wellenleitung ausgewählt ist.

8. Fotovoltaikmodul nach Anspruch 6 oder 7, **dadurch gekennzeichnet, dass** die Texturierung (80) eine Prismenanordnung ist.

9. Fotovoltaikmodul nach einem der vorhergehenden Ansprüche, **dadurch gekennzeichnet, dass** mindestens zwei Bänder auf jeder Seite jeder Zelle angeordnet sind, wobei die Bänder der ersten Seite auf einem Pluspol der Zelle angeordnet sind und die Bänder der zweiten Seite auf einem Minuspol der Zelle angeordnet sind, und dass die Verbindungselemente die Bänder der ersten Seite einer Zelle jeweils mit den Bändern der zweiten Seite einer benachbarten Zelle verbinden.

10. Verfahren zur Herstellung eines Fotovoltaikmoduls, Folgendes umfassend:
▪ eine für einfallende Strahlung durchlässige obere Platte (16) und eine untere Platte (18), die elektrisch isolierend und miteinander verkapselt sind, um ein hermetisches Gehäuse zu bilden;
▪ Fotovoltaikzellen (12, 14), die zwischen der oberen und unteren Platte (16, 18) eingepresst sind;
▪ mindestens zwei elektrisch leitende Kontakte (32 - 44), die auf mindestens einer Seite jeder Fotovoltaikzelle (12, 14) angeordnet sind, wobei sich mindestens ein elektrischer Kontakt (32 - 44) in Form eines Bands darstellt; und
▪ Elemente (52 - 56), welche die Kontakte jeder Zelle elektrisch mit den Kontakten mindestens einer Nachbarzelle verbinden;
**dadurch gekennzeichnet, dass** es darin besteht:
▪ Furchen in der oberen Platte und/oder unteren Platte auszubilden, wobei die Furchen aufweisen:
o eine Tiefe, die zwischen einem Viertel und Dreiviertel der Dicke des Bands in einem nicht komprimierten Zustand beträgt;
o eine Breite, die größer oder gleich der Breite ist, die das Band bei 85°C aufweist; und
o eine Länge, die größer oder gleich der Länge ist, die das Band bei 85°C aufweist,
▪ die erste Platte, die Zellen und die elektrischen Kontakte und die zweite Platte zu stapeln, wobei jede Furche ein Band aufnimmt;
▪ die so hergestellte Stapelung durch Verklebung oder Verpressung oder Verschweißung zu verkapseln.

11. Verfahren zur Herstellung eines Fotovoltaikmoduls nach Anspruch 10, **dadurch gekennzeichnet, dass** die Furchen durch Lasergravur gebildet werden.

## Claims

1. A photovoltaic module (10) comprising:
▪ an upper plate (16) transparent to an incident radiation and a lower plate (18), electrically insulating and sealed to each other to define a tight package;
▪ photovoltaic cells (12, 14) pressed between the upper and lower plates (16, 18);
▪ at least two electrically-conductive contacts (32-44) arranged on at least one surface of each photovoltaic cell (12, 14), at least one electric contact (32-44) being in the form of a strip; and
▪ elements (52-56) electrically connecting the contacts of each cell with the contacts of at least one adjacent cell;
wherein at least one strip (32-44) of each cell (12, 14) is housed in a groove (62-68) made in the plate (16, 18) in front of it, the groove (62-68) being defined by:
▪ a depth between one quarter and three quarters of the thickness of the strip (32-44) in a uncompressed state;
▪ a width greater than or equal to the width of the strip (32-44) at 85°C; and
▪ a length greater than or equal to the length of the strip (32-44) at 85°C.

2. The photovoltaic module of claim 1, wherein the depth of the groove (62-68) is substantially equal to half the thickness of the strip (32-44) in the uncompressed state.

3. The photovoltaic module of claim 1 or 2, wherein it comprises cells aligned in a row (78, 80, 82), strips arranged on the surfaces of said cells being aligned and housed in a single groove (62, 64) extending along at least the total length of the aligned cells.

4. The photovoltaic module of claim 1 or 2, wherein it comprises cells aligned in a row (78, 80, 82), strips arranged on the surfaces of said cells being aligned and housed in a plurality of separate grooves (62, 64) extending along all or part of the length of each cell.

5. The photovoltaic module of claim 4, wherein adjacent grooves are spaced apart by a distance shorter than the length of a space separating adjacent cells by at least a value equal to a linear expansion of the material forming the strips, induced by a temperature variation from 25°C to 85°C.

6. The photovoltaic module of any of the foregoing claims, wherein a surface of the plate at the bottom of the groove comprises a micron-scale texturing (80).

7. The photovoltaic module of claim 6, wherein the texturing (80) implements an optical function for the incident radiation selected from among refraction, reflection, scattering, diffraction, and wave guiding.

8. The photovoltaic module of claim 6 or 7, wherein the texturing (80) is a prism network.

9. The photovoltaic module of any of the foregoing claims, wherein at least two strips are arranged on each surface of each cell, the strips of the first surface being arranged on a negative pole of the cell, and wherein the connection elements connect the strips of the first surface of a cell respectively to the strips of the second surface of an adjacent cell.

10. A method of manufacturing a photovoltaic module comprising:
▪ an upper plate (16) transparent to an incident radiation and a lower plate (18), electrically insulating and sealed to each other to define a tight package;
▪ photovoltaic cells (12, 14) pressed between the upper and lower plates (16, 18);
▪ at least two electrically-conductive contacts (32-44) arranged on at least one surface of each photovoltaic cell (12, 14), at least one electric contact (32-44) being in the form of a strip; and
▪ elements (52-56) electrically connecting the contacts of each cell with the contacts of at least one adjacent cell;
wherein it comprises:
▪ forming grooves in one and/or the other of the upper plate and of the lower plate, the grooves having:
∘ a depth between one quarter and three quarters of the thickness of the strip in a uncompressed state;
∘ a width greater than or equal to the width of the strip at 85°C; and
∘ a length greater than or equal to the length of the strip at 85°C,
▪ stacking the first plate, the cells, and the electric contacts, and the second cell, each groove housing a strip;
▪ sealing the stack thus formed by gluing or by pressing or by welding.

11. The method of manufacturing a photovoltaic module of claim 10, wherein the grooves are formed by laser etching.
